# EUROPEAN PATENT APPLICATION

(11) **EP 1 538 682 A2**
(43) Date of publication of application: **08.06.2005**
(21) Application number: 04028770.8
(22) Date of filing: 03.12.2004
(51) Int. Cl.: H01L 33/00

(54) **Semiconductor light emitting device**

(30) Priority: 04.12.2003 JP 2003406398
(71) Applicant: NITTO DENKO CORPORATION, Osaka (JP)
(72) Inventor: Suehiro, Ichirou, Ibaraki-shi Osaka (JP); Hotta, Yuji, Ibaraki-shi Osaka (JP); Sadayori, Naoki, Ibaraki-shi Osaka (JP); Kamada, Takashi, Ibaraki-shi Osaka (JP)
(74) Representative: Grünecker, Kinkeldey, Stockmair & Schwanhäusser Anwaltssozietät

(57) **Abstract**

The invention provides an optical semiconductor device which comprises: an optical semiconductor element; a first resin layer encapsulating the optical semiconductor element and comprising a first resin and light-scattering particles; and one or more resin layers sequentially encapsulating the first resin layer and each comprising a resin having a lower refractive index than the first resin. In an embodiment where the optical semiconductor device has a plurality of resin layers over the first resin layer, the plurality of resin layers are disposed such that the refractive indexes of the constituting resins sequentially decrease toward the outermost resin layer.

## Description

### FIELD OF THE INVENTION

The present invention relates to an optical semiconductor device.

### BACKGROUND OF THE INVENTION

An optical semiconductor device is known which includes an optical semiconductor element encapsulated with two or more resin layers disposed in order of their decreasing refractive index from the optical-semiconductor element side toward the outermost layer so as to have an improved efficiency of light takeout (see patent documents 1 and 2).

Patent Document 1: JP 10-65220 A (claim 1)

Patent Document 2: JP 2000-49387 A (claim 1)

However, even in the optical semiconductor device described above, a large proportion of the light still remains unable to be taken out because of total light reflection at the interface between the first encapsulating resin and the second encapsulating resin due to a difference in refractive index between these resins.

### SUMMARY OF THE INVENTION

An object of the invention is to provide an optical semiconductor device having a high efficiency of light takeout.

Other objects and effects of the invention will become apparent from the following description.

The invention relates to the following:
(1) An optical semiconductor device which comprises:
   an optical semiconductor element;
   a first resin layer encapsulating said optical semiconductor element and comprising a first resin and light-scattering particles; and
   a second resin layer encapsulating said first resin layer and comprising a second resin having a lower refractive index than said first resin; and
(2) An optical semiconductor device which comprises:
   an optical semiconductor element;
   a first resin layer encapsulating said optical semiconductor element and comprising a first resin and light-scattering particles; and
   a plurality of resin layers sequentially encapsulating said first resin layer and each comprising a resin having a lower refractive index than said first resin, wherein said plurality of resin layers are disposed such that the refractive indexes of the resins constituting said plurality of resin layers sequentially decrease toward the outermost resin layer.

The optical semiconductor device of the invention has an excellent advantage that since the innermost encapsulating resin layer contains light-scattering particles, the efficiency of light takeout is exceedingly high.

### BRIEF DESCRIPTION OF THE DRAWINGS

Fig. 1 is a sectional view of a lamp type embodiment of the optical semiconductor device of the invention.
Fig. 2 is a sectional view of a surface mounting type embodiment of the optical semiconductor device of the invention.

The reference numerals and signs used in the drawings denote the followings, respectively.
1: optical semiconductor element
2a: lead frame
2b: substrate
2c: conductive layer
3: wire
4: light-scattering particle
5: first resin layer
6: second resin layer
7: third resin layer

### DETAILED DESCRIPTION OF THE INVENTION

The optical semiconductor device of the invention includes the following devices according to first and second aspects.

First Aspect: An optical semiconductor device which comprises:
an optical semiconductor element;
a first resin layer encapsulating the optical semiconductor element and comprising a first resin and light-scattering particles; and
a second resin layer encapsulating the first resin layer and comprising a second resin having a lower refractive index than the first resin.

Second Aspect: An optical semiconductor device which comprises:
an optical semiconductor element;
a first resin layer encapsulating the optical semiconductor element and comprising a first resin and light-scattering particles; and
a plurality of resin layers sequentially encapsulating the first resin layer and each comprising a resin having a lower refractive index than the first resin, wherein the plurality of resin layers are disposed such that the refractive indexes of the resins constituting said plurality of resin layers sequentially decrease toward the outermost resin layer.

In each aspect of the invention, the first resin layer with which an optical semiconductor element is encapsulated contains light-scattering particles. Because of this, total reflection at the interface between the first resin layer and the second resin layer (also in the second aspect, the resin layer with which the first resin layer is encapsulated is referred to as the second resin layer) can be reduced and the efficiency of light takeout can be greatly improved.

Examples of the light-scattering particles include particles of a resin, e.g., polystyrene, and inorganic particles, e.g., silica. Preferred of these are inorganic particles having a refractive index as high as 1.54 to 2.50. Examples of such inorganic particles include oxides of titanium, zirconium, indium, zinc, tin, antimony, and the like.

The average particle diameter of the light-scattering particles is preferably from 100 nm to 2 µm from the standpoints of efficiently obtaining a scattering effect and avoiding a decrease in transmittance.

The content of the light-scattering particles in the first resin layer is preferably 5 to 75% by volume, more preferably 10 to 30% by volume.

The optical semiconductor element is not particularly limited as long as it is one for ordinary use in optical semiconductor devices. Examples thereof include gallium nitride (GaN; refractive index, 2.5), gallium-phosphorus (GaP; refractive index, 2.9), and gallium-arsenic (GaAs; refractive index, 3.5). GaN is preferred of these because it emits a blue light and a white LED can be produced therefrom using a phosphor therewith.

The resins to be contained in the first resin layer, with which the optical semiconductor element is encapsulated, and in the second resin layer are not particularly limited as long as they have been selected while taking account of their refractive indexes. Specifically, the resins are selected so that the second resin has a lower refractive index than the first resin and that in the second aspect, the two or more resin layers with which the first resin layer is encapsulated are disposed in order of their decreasing refractive index of the resin toward the outermost resin layer. However, the refractive index of the first resin is preferably 1.6 or higher, more preferably 1.7 to 2.1, from the standpoint of heightening the efficiency of light takeout from the optical semiconductor element.

On the other hand, the refractive index of the second resin in the first aspect and the refractive index of the resin constituting the outermost resin layer in the second aspect are each preferably less than 1.6, more preferably 1.38 to 1.54, from the standpoint of heightening the efficiency of light takeout at a resin layer interface.

The specific refractive index difference between the first resin and second resin {[(refractive index of first resin) - (refractive index of second resin)]/(refractive index of first resin) x 100} is preferably 5 to 35% from the standpoint of heightening the efficiency of light takeout at the resin layer interface. In the second aspect, when the resin layers ranging from the layer next to the second resin layer to the outermost resin layer are referred to as the third resin layer, fourth resin layer, ···· in consecutive order and the resins respectively constituting these resin layers are referred to as the third resin, fourth resin, ···, then the specific refractive index difference between the resins of adjacent resin layers {[(refractive index of n-th resin) - (refractive index of (n+1)-th resin)]/(refractive index of n-th resin) x 100 (wherein n is an integer of 2 or larger)} also is preferably 5 to 35%.

Examples of the resins for encapsulating the optical semiconductor element include polyethersulfones, polyimides, aromatic polyamides, polycarbodiimides, epoxy resins, and heat-crosslinkable fluoropolymers.

Preferred of these for use as the first resin are polycarbodiimides from the standpoint of ease of processing at low temperatures and low pressures. More preferred is a polycarbodiimide represented by formula (1): 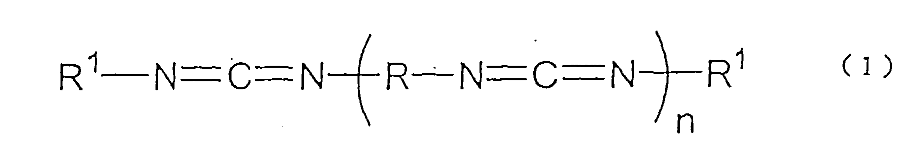 (wherein R represents a diisocyanate residue, R¹ represents a monoisocyanate residue, and n is an integer of 1-100).

In the invention, the polycarbodiimide represented by formula (1) is obtained by subjecting one or more diisocyanates to a condensate reaction and blocking the terminals of the resulting polymer with a monoisocyanate.

In formula (1), R represents a residue of the diisocyanate used as a starting material and R¹ represents a residue of the monoisocyanate used as another starting material. Symbol n is an integer of 1 to 100.

The diisocyanate and monoisocyanate to be used as starting materials may be either aromatic or aliphatic.
The diisocyanate and the monoisocyanate each may consist of one or more aromatic isocyanates alone or one or more aliphatic isocyanates alone, or may comprise a combination of an aromatic isocyanate and an aliphatic isocyanate.
From the standpoint of obtaining a polycarbodiimide having a higher refractive index, it is preferred to use aromatic isocyanates in the invention. Namely, it is preferred that at least either of the diisocyanate and the monoisocyanate comprises an aromatic isocyanate or consist of one or more aromatic isocyanates, or that each of the diisocyanate and the monoisocyanate consists of one or more aromatic isocyanates. More preferred is the case in which the diisocyanate comprises a combination of an aliphatic isocyanate and an aromatic isocyanate and the monoisocyanate consists of one or more aromatic isocyanates. Especially preferred is the case in which the diisocyanate and the monoisocyanate each consist of one or more aromatic isocyanates.

Examples of diisocyanates usable in the invention include hexamethylene diisocyanate, dodecamethylene diisocyanate, 2,2,4-trimethylhexamethylene diisocyanate, 4,4'-dichlorohexylmethane diisocyanate, xylylene diisocyanate, tetramethylxylylene diisocyanate, isophorone diisocyanate, cyclohexyl diisocyanate, lysine diisocyanate, methylcyclohexane 2,4'-diisocyanate, 4,4'-diphenylmethane diisocyanate, 4,4'-diphenyl ether diisocyanate, 2,6-tolylene diisocyanate, 2,4-tolylene diisocyanate, naphthalene diisocyanate, 1-methoxyphenyl 2,4-diisocyanate, 3,3'-dimethoxy-4,4'-diphenylmethane diisocyanate, 4,4'-diphenyl ether diisocyanate, 3,3'-dimethyl-4,4'-diphenyl ether diisocyanate, 2,2-bis[4-(4-isocyanatophenoxy)phenyl]-hexafluoropropane, and 2,2-bis[4-(4-isocyanatophenoxy)-phenyl]propane.

From the standpoints of enabling the polycarbodiimide to have a high refractive index and of ease of the control thereof, it is preferred to use, among those diisocyanates, at least one member selected from the group consisting of tolylene diisocyanate, 4,4'-diphenylmethane diisocyanate, naphthalene diisocyanate, hexamethylene diisocyanate, and dodecamethylene diisocyanate. More preferred is naphthalene diisocyanate.

Those diisocyanates can be used singly or as a mixture of two or more thereof. From the standpoint of heat resistance, however, it is preferred to use a mixture of two or three diisocyanates.

The one or more diisocyanates to be used as a starting material preferably comprise one or more aromatic diisocyanates in an amount of preferably 10% by mole or larger (upper limit, 100% by mole) based on all diisocyanates. These diisocyanates desirably are ones enumerated above as preferred examples.

Examples of monoisocyanates usable in the invention include cyclohexyl isocyanate, phenyl isocyanate, p-nitrophenyl isocyanate, p- and m-tolyl isocyanates, p-formylphenyl isocyanate, p-isopropylphenyl isocyanate, and 1-naphthyl isocyanate.

Preferred monoisocyanates are aromatic monoisocyanates because aromatic monoisocyanates do not react with each other and the terminal blocking of a polycarbodiimide with such monoisocyanates proceeds efficiently. It is more preferred to use 1-naphthyl isocyanate.

Those monoisocyanates can be used singly or as a mixture of two or more thereof.

The amount of the monoisocyanate to be used for terminal blocking is preferably in the range of from 1 to 10 mol per 100 mol of the diisocyanate ingredient to be used, from the standpoint of storage stability.

The polycarbodiimide according to the invention can be produced by converting one or more diisocyanates as a starting material to a carbodiimide through condensation reaction in a predetermined solvent in the presence of a catalyst for carbodiimide formation and blocking the terminals of the resultant carbodiimide polymer with a monoisocyanate.

The diisocyanate condensation reaction is conducted at a temperature of generally from 0 to 150°C, preferably from 10 to 120°C.

In the case where an aliphatic diisocyanate and an aromatic diisocyanate are used in combination as starting-material diisocyanates, it is preferred to react the diisocyanates at a low temperature. The reaction temperature is preferably from 0 to 50°C, more preferably from 10 to 40°C. Use of a reaction temperature in this range is preferred because the condensation of the aliphatic diisocyanate with the aromatic diisocyanate proceeds sufficiently.

In the case where an excess aromatic diisocyanate present in the reaction mixture is desired to be further reacted with the polycarbodiimide formed from an aliphatic diisocyanate and an aromatic diisocyanate, the reaction temperature is preferably from 40 to 150°C, more preferably from 50 to 120°C. As long as the reaction temperature is within this range, any desired solvent can be used to smoothly conduct the reaction. The reaction temperature range is therefore preferred.

The diisocyanate concentration in the reaction mixture is preferably from 5 to 80% by weight. As long as the diisocyanate concentration is within this range, carbodiimide formation proceeds sufficiently and reaction control is easy. The diisocyanate concentration range is therefore preferred.

Terminal blocking with a monoisocyanate can be accomplished by adding the monoisocyanate to the reaction mixture in an initial, middle, or final stage of carbodiimide formation from the diisocyanate(s) or throughout the carbodiimide formation. The monoisocyanate is preferably an aromatic monoisocyanate.

As the catalyst for carbodiimide formation, any of known phosphorus compound catalysts can be advantageously used. Examples thereof include phospholene oxides such as 1-phenyl-2-phospholene 1-oxide, 3-methyl-2-phospholene 1-oxide, 1-ethyl-2-phospholene 1-oxide, 3-methyl-1-phenyl-2-phospholene 2-oxide, and the 3-phospholene isomers of these.

The solvent (organic solvent) to be used for producing the polycarbodiimide is a known one. Examples thereof include halogenated hydrocarbons such as tetrachloroethylene, 1,2-dichloroethane, and chloroform, ketone solvents such as acetone, methyl ethyl ketone, methyl isobutyl ketone, and cyclohexanone, cyclic ether solvents such as tetrahydrofuran and dioxane, and aromatic hydrocarbon solvents such as toluene and xylene. These solvents can be used singly or as a mixture of two or more thereof. These solvents are used also for dissolving the obtained polycarbodiimide.

The end point of the reaction can be ascertained by infrared spectroscopy (IR analysis) from the occurrence of absorption attributable to the carbodiimide structure (N=C=N) (2,140 cm⁻¹) and the disappearance of absorption attributable to the isocyanates (2,280 cm⁻¹).

After completion of the carbodiimide-forming reaction, a polycarbodiimide is obtained usually in the form of a solution. However, the solution obtained may be poured into a poor solvent such as methanol, ethanol, isopropyl alcohol, or hexane to precipitate the polycarbodiimide and remove the unreacted monomers and the catalyst.

In preparing a solution of the polycarbodiimide which has been recovered as a precipitate, the precipitate is washed and dried in a predetermined manner and then dissolved again in an organic solvent. By performing this operation, the polycarbodiimide solution can have improved storage stability.

In the case where the polycarbodiimide solution contains by-products, the solution may be purified, for example, by adsorptively removing the by-products with an appropriate adsorbent. Examples of the adsorbent include alumina gel, silica gel, activated carbon, zeolites, activated magnesium oxide, activated bauxite, Fuller's earth, activated clay, and molecular sieve carbon. These adsorbents can be used singly or in combination of two or more thereof.

By the method described above, the polycarbodiimide according to the invention is obtained. From the standpoint of enabling the polycarbodiimide constituting the first resin layer to have a higher refractive index, the polycarbodiimide preferably is one in which the backbone structure is constituted of aromatic and aliphatic diisocyanates and the terminals have been blocked with an aromatic monoisocyanate. More preferred is one in which the backbone structure is constituted of one or more aromatic diisocyanates and the terminals have been blocked with an aromatic monoisocyanate.

Specifically, the polycarbodiimide preferably is one in which 10% by mole or more (upper limit, 100% by mole) of the diisocyanate residues represented by R in formula (1) are residues of one or more aromatic diisocyanates and the monoisocyanate residues represented by R¹ in formula (1) are residues of one or more aromatic monoisocyanates. The diisocyanate residues preferably are residues of at least one member selected from the group consisting of tolylene diisocyanate, 4,4'-diphenylmethane diisocyanate, naphthalene diisocyanate, hexamethylene diisocyanate, and dodecamethylene diisocyanate, and more preferably are naphthalene diisocyanate residues. The aromatic monoisocyanate residues preferably are 1-naphthyl isocyanate residues.

On the other hand, the resin of each of the second and succeeding resin layers is preferably an epoxy resin or a heat-crosslinkable fluoropolymer from the standpoints of ease of molding and low cost.

The encapsulation of an optical semiconductor element with the first resin layer can be conducted by dipping, dispenser coating, spin coating, or the like in the same manner as in an ordinary technique, except that light-scattering particles are incorporated into the layer.

Examples thereof include a method which comprises mixing a first resin and light-scattering particles with an organic solvent to prepare a resin solution containing the light-scattering particles dispersed therein, coating the surface of an optical semiconductor element with the resin solution by any of the above-mentioned methods, and then heating and drying the coated element.

As the organic solvent, solvents that can dissolve the resin therein, such as, e.g., toluene and cyclohexanone, can be appropriately selected.

The viscosity of the resin solution containing the light-scattering particles dispersed therein is preferably about 0.01 to 1 Pa·s.

The thickness of the first resin layer cannot be determined unconditionally because it depends on the wavelength of the light to be emitted, regardless of the length of each side of the optical semiconductor element. However, from the standpoint of preventing light attenuation during light transmission, the thickness thereof is preferably 300 µm or smaller, more preferably 50 µm or smaller, especially preferably 30 µm or smaller. On the other hand, the lower limit thereof is preferably 100 nm from the standpoint of obtaining a high efficiency of light takeout.

Encapsulation with the second and succeeding resin layers can be conducted by a method appropriately selected from known ones such as, e.g., injection molding, casting, transfer molding, dipping, and potting with a dispenser or the like.

It is preferred that the second resin layer of the optical semiconductor device according to the first aspect and the outermost resin layer of the optical semiconductor device according to the second aspect contain silica particles from the standpoint of scratch resistance.

The average particle diameter of the silica particles is preferably 1 to 100 nm, more preferably 5 to 30 nm.

The content of the silica particles in the outermost resin layer is preferably 5 to 35% by volume, more preferably 15 to 25% by volume.

As long as an optical semiconductor element has been encapsulated with resin layers having regulated refractive indexes as described above, the other constitutions of the optical semiconductor device of the invention is not particularly limited and may be the same as known optical semiconductor devices,. Consequently, the shape of the device also is not particularly limited, and examples include lamp type devices and surface mounting type devices.

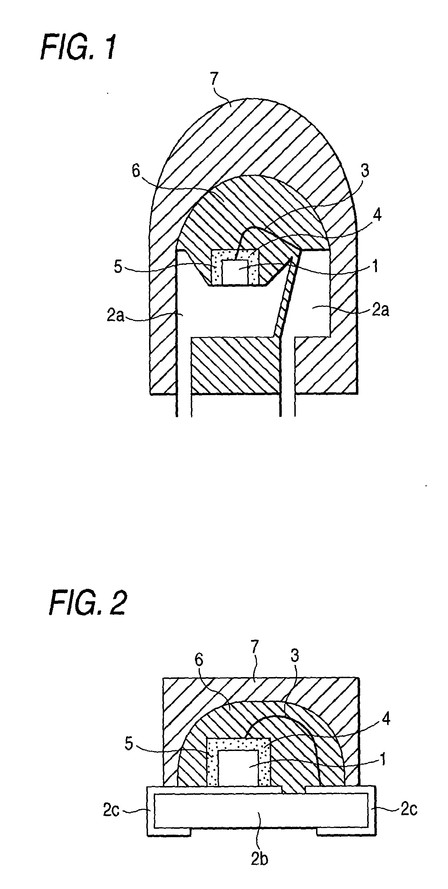

Sectional views of lamp type and surface mounting type embodiments of the optical semiconductor device according to the second aspect of the invention are shown in Figs. 1 and 2.

The lamp type optical semiconductor device shown in Fig. 1 includes an optical semiconductor element 1 disposed on a lead frame 2a and connected to another lead frame 2a by a wire 3. This optical semiconductor element 1 has been encapsulated with a first resin layer 5 containing light-scattering particles 4. The first resin layer 5 has been encapsulated with a second resin layer 6 so that the wire 3 is embedded in the layer 6. Furthermore, this structure has been encapsulated with a third resin layer 7 as the outermost layer so that the whole device is protected.

On the other hand, the surface mounting type optical semiconductor device shown in Fig. 2 includes an optical semiconductor element 1 which has been disposed on an electrically conductive layer 2c formed on a substrate 2b and has been connected to another conductive layer 2c by a wire 3. This optical semiconductor element 1 has been encapsulated with a first resin layer 5 containing light-scattering particles 4. The first resin layer 5 has been encapsulated with a second resin layer 6 so that the wire 3 is embedded in the layer 6. Furthermore, the second resin layer 6 has been encapsulated with a third resin layer 7 as the outermost layer.

### EXAMPLES

The present invention will be illustrated in greater detail with reference to the following Examples, but the invention should not be construed as being limited thereto.

In the following Examples, all synthesis reactions were conducted in a nitrogen stream. IR analysis was made with FT/IR-230 (manufactured by Nippon Bunko K.K.).

### Polycarbodiimide Production Example

Into a 500-mL four-necked flask equipped with a stirrer, dropping funnel, reflux condenser, and thermometer were introduced 29.89 g (171.6 mmol) of tolylene diisocyanate (isomer mixture; T-80, manufactured by Mitsui-Takeda Chemical), 94.48 g (377.52 mmol) of 4,4'-diphenylmethane diisocyanate, 64.92 g (308.88 mmol) of naphthalene diisocyanate, and 184.59 g of toluene. These ingredients were mixed together.

Thereto were added 8.71 g (51.48 mmol) of 1-naphthyl isocyanate and 0.82 g (4.29 mmol) of 3-methyl-1-phenyl-2-phospholene 2-oxide. The resultant mixture was heated to 100°C with stirring and held for 2 hours.

The end point of the reactions was ascertained by IR analysis and the reaction mixture was cooled to room temperature. Thus, a polycarbodiimide solution was obtained. In this polycarbodiimide, 100% by mole of the diisocyanate residues were aromatic diisocyanate residues. This polycarbodiimide was represented by formula (1) described above wherein n ranged from 15 to 77.

The polycarbodiimide was formed into a 30 µm-thick sheet through 1-hour curing at 150°C. The refractive index of this polycarbodiimide was measured with a multi-wavelength Abbe's refractometer (DR-M4, manufactured by ATAGO) at a wavelength of 589 nm and a temperature of 25°C and was found to be 1.748.

### EXAMPLE 1

To the polycarbodiimide solution obtained in the above-described Production Example was added a silica slurry (cyclohexanone dispersion; silica content, 30% by weight; average silica particle diameter, 1 µm; manufactured by Admatechs Co. Ltd.) in such a proportion as to result in a silica particle content after cure of 25% by volume. The ingredients were mixed together to disperse the silica particles. Furthermore, the dispersion obtained was diluted with cyclohexanone to a solid content of 9% by weight (viscosity, 10 Pa·s or lower). Thus, a first resin solution was obtained.

An optical semiconductor element (GaN; 0.35 mm × 0.35 mm × 0.08 mm) mounted on a lead frame was immersed in the first resin solution for 5 seconds, subsequently pulled out, and then dried in a 120°C drying oven for 30 minutes to thereby encapsulate the optical semiconductor element with a first resin layer composed of the polycarbodiimide with a refractive index of 1.748 and having a thickness of 5 µm.

Subsequently, a bullet-shaped mold was used to form a second resin layer from an epoxy resin having a refractive index of 1.54 (NT-8002, manufactured by Nitto Denko) on the outer side of the first resin layer. Thus, a lamp type optical semiconductor device was obtained.

### EXAMPLE 2

A 6% by weight methyl ethyl ketone solution of a heat-crosslinkable fluoropolymer (refractive index, 1.42) (JN-7228, manufactured by JSR Co., Ltd.) was subjected to solvent displacement in which the methyl ethyl ketone was displaced by a mixed solvent consisting of 85% by weight methyl isobutyl ketone and 15% by weight 2-butanol.

To 70 parts by weight of the polymer solution obtained were added 10 parts by weight of a methyl ethyl ketone dispersion of silica sol (MEK-ST, manufactured by Nissan Chemical Industries, Ltd.; average silica particle diameter, 10-20 nm; solid concentration, 30% by weight), 42 parts by weight of methyl isobutyl ketone, and 28 parts by weight of cyclohexanone. This mixture was stirred to prepare a third resin solution.

The optical semiconductor device obtained by the method used in Example 1 was immersed in the third resin solution for 5 seconds and dried in a 120°C drying oven for 8 minutes to form a third resin layer having a refractive index of 1.42 from the heat-crosslinkable fluoropolymer on the outer side of the second resin layer. Thus, an optical semiconductor device was obtained.

### COMPARATIVE EXAMPLE 1

An optical semiconductor device was produced in the same manner as in Example 1, except that the light-scattering particles were not used.

### COMPARATIVE EXAMPLE 2

An optical semiconductor element (GaN) mounted on a lead frame was encapsulated with an epoxy resin (NT-8002, manufactured by Nitto Denko; refractive index, 1.54) by transfer molding using a bullet-shaped mold. Thus, an optical semiconductor device was obtained.

### TEST EXAMPLE

A voltage was applied to the optical semiconductor devices produced in the Examples and Comparative Examples to measure the quantity of light emitted by each device. In this light quantity measurement, the quantity of overall light emitted was measured with MCPD-3000 (manufactured by Otsuka Electronics Co., Ltd.) using an integrating sphere. The results obtained are shown in Table 1.

**Table 1**

| | Quantity of light emitted [µW/cm²/nm] |
|---|---|
| Example 1 | 0.77 |
| Example 2 | 0.79 |
| Comparative Example 1 | 0.68 |
| Comparative Example 2 | 0.62 |

The results given above show that the optical semiconductor devices obtained in the Examples, in which the first resin layer encapsulating the optical semiconductor element contained light-scattering particles, emitted a larger quantity of light than the optical semiconductor devices of the Comparative Examples. It can hence be seen that the devices of the Examples had a high efficiency of light takeout.

The optical semiconductor device of the invention is suitable for use in displays, signals, and the like.

While the invention has been described in detail and with reference to specific embodiments thereof, it will be apparent to one skilled in the art that various changes and modifications can be made therein without departing from the spirit and scope thereof.

The present application is based on Japanese patent application No. 2003-406398 filed December 4, 2003, the contents thereof being herein incorporated by reference.

## Claims

1. An optical semiconductor device which comprises:
an optical semiconductor element;
a first resin layer encapsulating said optical semiconductor element and comprising a first resin and light-scattering particles; and
a second resin layer encapsulating said first resin layer and comprising a second resin having a lower refractive index than said first resin.

2. The optical semiconductor device of claim 1, wherein said first resin layer has a thickness of 300 µm or smaller.

3. The optical semiconductor device of claim 1 or 2, wherein said first resin has a refractive index of 1.6 or higher.

4. The optical semiconductor device of any one of claims 1 to 3, wherein said light scattering particles comprises inorganic particles having a refractive index of 1.54 to 2.50.

5. The optical semiconductor device of any one of claims 1 to 4, wherein said light scattering particles have an average particle diameter of from 100 nm to 2 µm.

6. The optical semiconductor device of any one of claims 1 to 5, wherein said first resin layer contains said light scattering particles in an amount of 5 to 75% by volume.

7. The optical semiconductor device of any one of claims 1 to 6, wherein said first resin comprises a polycarbodiimide.

8. An optical semiconductor device which comprises:
an optical semiconductor element;
a first resin layer encapsulating said optical semiconductor element and comprising a first resin and light-scattering particles; and
a plurality of resin layers sequentially encapsulating said first resin layer and each comprising a resin having a lower refractive index than said first resin, wherein said plurality of resin layers are disposed such that the refractive indexes of the resins constituting said plurality of resin layers sequentially decrease toward the outermost resin layer.

9. The optical semiconductor device of claim 8, wherein the first resin has a refractive index of 1.6 or higher.

10. The optical semiconductor device of claim 8 or 9, wherein the outermost resin layer has a refractive index of less than 1.6.

11. The optical semiconductor device of any one of claims 8 to 10, wherein said light scattering particles comprises inorganic particles having a refractive index of 1.54 to 2.50.

12. The optical semiconductor device of any one of claims 8 to 11, wherein said light scattering particles have an average particle diameter of from 100 nm to 2 µm.

13. The optical semiconductor device of any one of claims 8 to 12, wherein said first resin layer contains said light scattering particles in an amount of 5 to 75% by volume.

14. The optical semiconductor device of any one of claims 8 to 13, wherein said first resin comprises a polycarbodiimide.

15. The optical semiconductor device of any one of claims 8 to 14, wherein the outermost layer further comprises silica particles having an average particle diameter of 1 to 100 nm.
